# EUROPEAN PATENT APPLICATION

(11) **EP 0 668 372 A1**
(43) Date of publication of application: **23.08.1995**
(21) Application number: 95300516.2
(22) Date of filing: 27.01.1995
(51) Int. Cl.: C23C 16/26

(54) **Semi-transparent diamond film**

(30) Priority: 16.02.1994 US 195673
(71) Applicant: GENERAL ELECTRIC COMPANY, Schenectady, NY 12345 (US)
(72) Inventor: Anthony, Thomas Richard, Schenectady, New York 12309 (US); Fleischer, James Fulton, Scotia, New York 12302 (US)
(74) Representative: Szary, Anne Catherine

(57) **Abstract**

A method is provided for making semi-transparent polycrystalline diamond film having a thickness greater than 50 microns which can be used as a heat sink in microelectronic applications. A mixture of hydrogen and a carbon-fluorine containing material such as carbon tetrafluoride is conveyed into a heated filament reaction zone adjacent to an appropriate substrate, such as molybdenum to produce non-adherent semi-transparent diamond film.

## Description

### Reference to Related Application

Reference is made to copending application RD-23105 filed concurrently herewith (US Serial No. 08/195,672).

### Background of the Invention

The present invention relates to a chemical vapor deposition (CVD) method for making semi-transparent free-standing polycrystalline diamond film. More particularly, the present invention relates to the formation of diamond film using a mixture comprised of hydrogen and a carbon polyfluoride, such as carbon tetrafluoride, in a heated reaction zone adjacent to a substrate, such as molybdenum.

As shown by Anthony et al U.S. patent 5,110,579, which is incorporated herein by reference, continuous free-standing substantially transparent diamond film can be made by utilizing a mixture of hydrogen and methane in a heated reaction zone. It has been found that diamond films made from hydrogenmethane mixtures can have various degrees of transparency depending upon such factors as film thickness, the volume % of the methane used in the reaction mixture during film formation etc. As discussed in U.S. 5,110,579, disassociation of hydrogen atoms and methane in a heated reaction zone is sufficient to generate active carbon-hydrogen species leading to diamond film formation.

Copending application RD-23105, shows that diamond films having improved transparency can be made by the chemical vapor deposition (CVD) of mixtures of hydrogen and a carbon polychloride as compared to CVD films made from hydrogen and methane. It would be desirable to provide additional procedures for making free-standing semi-transparent diamond films.

### Summary of the Invention

The present invention is based on the discovery that free-standing, substantially transparent, semi-transparent, or translucent polycrystalline diamond film, having a thickness of at least 50 microns, such as up to 5000 microns, and preferably 200 to 1000 microns, can be made by using a mixture of hydrogen and a carbon-fluorine containing material, such as carbon tetrafluoride, in a heated reaction zone. It has been found that such diamond film has an improved degree of "optical transparency" and thermal conductivity. Optical transparency is an empirical definition used to establish the degree of transparency of diamond film made in accordance with the practice of the invention. The optical transparency of an unevaluated diamond film is determined by comparing it with a standard transparent diamond film having a comparable thickness. For definition purposes, a standard diamond film is a diamond film made in accordance with the procedure shown by Anthony et al, U.S. patent 5,110,579. In evaluating a diamond film for degree of optical transparency, the sample diamond film having approximately the same thickness as the standard, is placed side by side under a visible light source with the standard diamond film on printed text, such as a U.S. patent. The degree of optical transparency can be determined empirically by reading the printed text through the diamonds. In addition to optical transparency, the fluorine containing diamond films made in accordance with the practice of the invention also have been found to have enhanced thermal conductivity as compared to CVD diamond made by using a mixture of hydrogen with either methane or a carbon-polychloride which is made in accordance with copending application RD-23105.

### Statement of the Invention

There is provided by the present invention, a continuous free-standing polycrystalline diamond film having a thickness of at least 50 microns comprising (A) substantially vertical columnar diamond crystals having a <110> orientation perpendicular to the base and up to 10,000 parts per million of chemically combined fluorine atoms, or a mixture of fluorine atoms and hydrogen atoms which are sufficient to substantially saturate dangling carbon atoms at diamond crystal grain boundaries, carbon dislocations, and carbon valance vacancies and (B) diamond crystal grain boundaries separating the columnar diamond crystals of (A), where the diamond crystal grain boundaries have a 70°-90° orientation to the diamond crystal base.

In another aspect of the present invention, there is provided a method of making a non- adherent free-standing, semi-transparent polycrystalline diamond film on a substrate which method comprises, passing a mixture of hydrogen and a carbon-fluorine containing material through a heated reaction zone at a temperature of about 700°C to about 900°C and at a pressure from about 3 to about 24 torr which is sufficient to generate active atomic species comprising carbon-F species, or a mixture of carbon-F species and carbon-hydrogen species in the heated reaction zone maintained at a distance of from about 0.3 to about 1 centimeter from the surface of the substrate, where the mixture of hydrogen and the carbon-fluorine containing material introduced into the heated reaction zone is a member selected from the group consisting of,
(a) a mixture of hydrogen and from about 0.1 to about 2.0 volume %, based on the total volume of mixture, of a gaseous blend of from 25 to 75 mole % of methane and from about 25 to about 75 mole % of a carbon polyfluoride of the formula, C(H)ₐF₄₋ₐ, where "a" is a whole number equal to 0 to 3 inclusive, and
(b) a mixture of hydrogen and from about 7.5 to about 12 volume %, based on the total volume of mixture, of the carbon polyfluoride of (a).

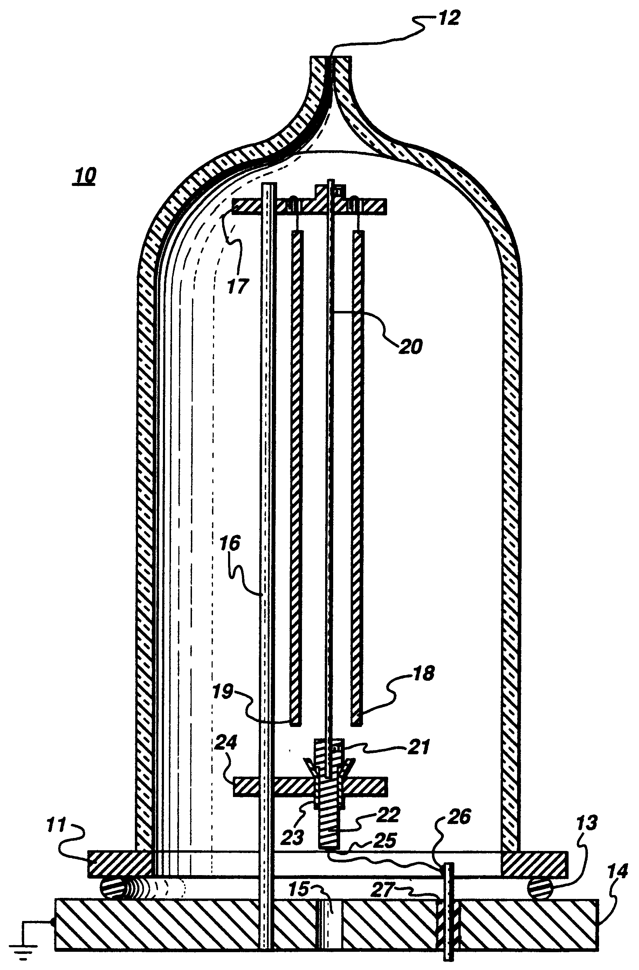

### Brief Description of the Drawing

A typical apparatus which can be used to form the transparent polycrystalline diamond film of the present invention is shown by the drawing. The drawing shows a quartz bell jar having a metal flange which rests on a base. Inside the quartz bell jar, there is shown a support structure for a filament and several adjacent substrate sections.

More particularly, there is shown a quartz bell jar at **10** which be 20''-30'' tall and about 4''-6'' wide having a metal collar at its base at **11** and a gas inlet at the top at **12**. The metal collar portion rests on a rubber seal at **13** which can be Neoprene rubber. The rubber seal is supported by a metal base, such as steel base structure at **14** which has a vacuum opening at **15**.

Inside the quartz bell jar there is shown a supporting stand at **16** for an extension at **17** for holding several substrate structures, such as molybdenum at **18** and **19** and a filament at **20**. The filament is secured by a screw at **21** to a metal plug at **22** which passes through a quartz insulating collar at **23** which is supported by an extension at **24**. Electrical contacts are shown from the plug at **25** to a stud at **26** which is insulated from the metal base at **27**.

A detailed discussion of Miller Indices describing crystal planes of atoms differentiating between <010>, <110> and <111> orientation is shown on pages 65-69 in *Elements of Material Science*, Second Edition, 1964, by Lawrence H. VanVlack of Addison-Wisley Publishing Company, Reading, Mass. which is incorporated herein by reference.

The polycrystalline diamond films made in accordance with the practice of the present invention can be used in a variety of glazing applications as well as heat sinks or semiconductors.

In order that those skilled in the art will be better able to practice the present invention, the following example is given by way of illustration and not by way of limitation.

### Example

A mixture of about 1 volume % methane, about 0.5 volume % carbon tetrafluoride, and about 98.5 volume % hydrogen measured under atmospheric conditions was introduced into a reaction vessel as shown by in the drawing. A gas flow rate of about 400 cubic centimeters per minute was maintained. There was used two 1 1/4'' X 1/4'' X 9'' molybdenum substrates and two 24 centimeters 218 tungsten filaments having a diameter of 0.016''. The tungsten filament was maintained at a temperature between about 2000°C to 2100°C A separation of about 10 millimeters was maintained between the filament and the molybdenum substrate during the deposition which lasted about 34 days. The substrate temperature was estimated at about 734°C during the deposition period.

At the termination of the deposition period, the apparatus was allowed to cool to room temperature. A transparent diamond film was obtained, referred to hereinafter as "fluorinated diamond film 1" having a thickness of about 255 microns separated from the substrate during the cooling period.

The above procedure is repeated, except that a mixture of about 8 volume % of carbon tetrafluoride and about 92 volume % of hydrogen is used. There is obtained a transparent diamond film having a thickness substantially similar to fluorinated diamond film 1 and referred to hereinafter as "fluorinated diamond film 2".

A transparent diamond film is prepared in accordance with the method of Anthony et al, U.S. 5,110,579. In preparing the diamond film, a reaction mixture is used consisting of about 1.5 volume % of methane and 98.5 volume % of hydrogen. There is obtained a free-standing, polycrystalline, transparent diamond film referred to hereinafter as the "standard" having a thickness substantially similar in microns to fluorinated diamond films 1 and 2.

The optical transparencies of the fluorinated diamond films 1 and 2 were found to be substantially greater than the standard diamond film with respect to the clarity of printed text read through the diamonds when placed side by side under a fluorescent light.

In addition, fluorinated diamonds 1 and 2 were found to have enhanced thermal conductivity over the standard when measured by the Mirage technique shown by R. W. Pryor et al proceedings of the Second International Conference On New Diamond Science And Technology, p. 863(1990).

Although the above example is directed to only a few of the very many variables to which the present invention is directed, it should be understood that the present invention includes additional parameters as shown in the description preceding this example.

## Claims

1. A continuous free-standing, polycrystalline diamond film comprising (A) substantially vertical columnar diamond crystals having a <110> orientation perpendicular to the base and up to 10,000 parts per million of chemically combined fluorine atoms, or a mixture of fluorine atoms and hydrogen atoms which are sufficient to substantially saturate dangling carbon atoms at diamond crystal grain boundaries,carbon dislocations,and carbon valance vacancies and (B) diamond crystal grain boundaries separating the columnar diamond crystals of (A),where the diamond crystal grain boundaries have a 70°-90° orientation to the diamond crystal base.

2. A continuous free-standing diamond film in accordance with claim 1, having a thickness of about 200 to about 1000 microns.

3. A transparent diamond diamond film in accordance with claim 1, having a thickness of 50 to 5000 microns.

4. A method of making a non- adherent free-standing, semi-transparent polycrystalline diamond film on a substrate which method comprises, passing a mixture of hydrogen and a carbon-fluorine containing material through a heated reaction zone at a temperature of about 700°C to about 900°C and at a pressure from about 3 to about 24 torr which is sufficient to generate active atomic species comprising carbon-F species, or a mixture of carbon-F species and carbon-hydrogen species in the heated reaction zone maintained at a distance of from about 0.3 to about 1 centimeter from the surface of the substrate, where the mixture of hydrogen and the carbon-fluorine containing material introduced into the heated reaction zone is a member selected from the group consisting of,
(a) a mixture of hydrogen and from about 0.1 to about 2.0 volume %, based on the total volume of mixture, of a gaseous blend of from 25 to 75 mole % of methane and from about 25 to about 75 mole % of a carbon polyfluoride of the formula, C(H)ₐF₄₋ₐ, where "a" is a whole number equal to 0 to 3 inclusive, and
(b) a mixture of hydrogen and from about 7.5 to about 12 volume %, based on the total volume of mixture, of the carbon polyfluoride of (a).

5. A method in accordance with claim 4, where the carbon-fluorine containing material is a mixture of methane and carbon tetrafluoride.

6. A method in accordance with claim 4, where the carbon-fluorine containing material is carbon tetrafluoride used at 8 to 9 volume % based on the total volume of hydrogen and carbon tetrafluoride.
